# FASCICULE DE BREVET EUROPEEN

(11) **EP 2 891 178 B1**
(45) Date de publication et mention de la délivrance du brevet: **06.05.2020**
(21) Numéro de dépôt: 13756619.6
(22) Date de dépôt: 29.07.2013
(51) Int. Cl.: H01L 25/07, H01L 23/40, H05K 7/20

(54) **ORGANE DE PLAQUAGE D'UNE PIÈCE SUR UNE SURFACE**
KÖRPER ZUM PRESSEN EINES TEILS AUF EINE OBERFLÄCHE
BODY FOR PRESSING A PART AGAINST A SURFACE

(30) Priorité: 29.08.2012 FR 1258059
(43) Date de publication de la demande: 08.07.2015
(73) Titulaire: Valeo Systèmes de Contrôle Moteur, 95892 Cergy Pontoise (FR)
(72) Inventeur: MORIN, Damien, F-45220 Chuelles (FR); MORLIERE, Benjamin, F-95520 Osny (FR)
(74) Mandataire: Argyma
(86) Numéro de dépôt international: PCT/FR2013/051826
(87) Numéro de publication internationale: WO 2014/033382

(56) Documents cités:
- EP-A2- 1 351 302
- DE-A1-102007 050 985
- DE-C1- 10 052 191
- US-A- 5 466 970
- US-A1- 2005 230 820
- US-A1- 2009 067 131
- US-A1- 2009 244 847

## Description

La présente invention se rapporte à un organe de plaquage, notamment pour plaquer un module électronique dans un bloc électronique de puissance.

On connaît dans l'art antérieur des modules de puissance destinés à faire partie d'un tel bloc de puissance, notamment des modules de puissance à Grille de connexion Moulée Isolée ou module IML (pour « Insulated Moulded Leadframe » en anglais) de la demande de brevet français FR2833802 au nom de la demanderesse. Typiquement, le module de puissance comprend un boîtier dans lequel sont logés un ou plusieurs composants électroniques de puissance. Le bloc de puissance comprend en outre au moins une carte électronique de commande. La carte électronique de commande est typiquement une carte à circuits imprimés ou PCB (pour « printed circuit board » en anglais). Le module de puissance et la carte électronique de commande sont connectés électriquement afin d'assurer les fonctions du bloc de puissance. Typiquement, le module et la carte sont logés dans un carter du bloc de puissance.

En fonctionnement, le chauffage intempestif des composants électroniques de puissance nuit à leur fiabilité et peut entraîner des dommages provoquant un effet néfaste sur la durée de vie du bloc de puissance. Afin d'évacuer la chaleur formée dans le boîtier du module électronique de puissance, il est connu de presser ou plaquer le module contre un fond du carter et de choisir les matériaux du fond du boîtier du module électronique de puissance et du fond du carter de sorte qu'ils soient compatibles en terme de conductivité thermique. Typiquement, un fluide de refroidissement est en contact avec le fond du carter. Ainsi, la chaleur formée dans le boîtier est évacuée par le fond du boîtier et le fond du carter avant qu'elle ne vienne détériorer les composants du module. La durée de vie du bloc de puissance en est fortement améliorée.

Le document EP2172971 divulgue un organe permettant de plaquer un composant électronique contre une paroi. L'organe de plaquage comprend une languette et un élément élastiquement déformable en forme de ruban ondulé. La languette présente une patte de fixation à la surface de plaquage à chacune de ses extrémités. Le ruban comprend une première série d'arrondis et une deuxième série d'arrondis qui sont intercalés entre les arrondis de la première série. Lorsque l'organe plaque un composant contre une paroi, la languette a une face en regard du composant, les arrondis de la première série viennent en appui sur cette face et les arrondis de la seconde série viennent en appui sur le composant pour le plaquer sur le support. Cependant, l'utilisation d'une telle pièce impose la mise en place de deux parties distinctes à savoir la languette et le ruban, ce qui complexifie l'opération de plaquage.

Le document DE10052191 décrit un organe de plaquage selon le préambule de la revendication 1.

Il est donc recherché un organe de plaquage plus simple permettant de plaquer une pièce sur une surface, notamment un module électronique de puissance sur une surface de dissipation thermique.

A cet effet, il est proposé un organe de plaquage d'une pièce sur une surface d'un support, l'organe de plaquage étant notamment agencé pour être monté dans un bloc électronique de puissance, ledit organe comprenant :
- une plaque ayant une forme allongée suivant un axe longitudinal,
- au moins une patte élastiquement déformable comportant un bord de raccord rattachant la patte à la plaque et un bord d'extrémité libre destiné à plaquer ladite pièce, et
- des moyens destinés à fixer l'organe sur le support comprenant au moins une paroi s'étendant sensiblement perpendiculairement depuis une périphérie de la plaque, ladite paroi se terminant par une découpe définissant deux pattes latérales s'étendant du côté de la paroi qui est opposé à la plaque de façon à former un angle aigu avec le plan de la paroi.

L'axe longitudinal est notamment un axe médian de la plaque. En particulier l'axe longitudinal est défini par l'intersection d'un plan perpendiculaire à la plaque qui la sépare en deux parties symétriques.

Dans le cadre de la présente demande, par élément élastiquement déformable on entend un élément qui revient à une position initiale en l'absence de contrainte. Les pattes sont par exemple élastiquement déformables de par leur forme de languette.

Les pattes étant rattachées à la plaque, l'opération de plaquage peut être obtenue en rapprochant la plaque de la pièce sans rapporter un élément supplémentaire. Lorsque l'organe vient plaquer une pièce sur une surface, les bords d'extrémité libres des deux pattes exercent un effort sur la pièce pour la maintenir en contact avec la surface. Pour chaque patte cet effort peu comprendre une composante sensiblement perpendiculaire à la pièce qui plaque celle-ci sur la surface, mais aussi une composante latérale qui peut entraîner le glissement de la pièce sur la surface, voir son arrachage de la surface. Ceci est en particulier le cas si les pattes s'étendent depuis la plaque suivant une direction transverse pour converger l'une vers l'autre. Les bords d'extrémité libres étant en regard et situées de part et d'autre de l'axe longitudinal, les composantes latérales des efforts exercés par les pattes se compensent. Ainsi, un glissement ou un arrachage de la pièce provoqué par les pattes est évité. La fourniture d'une seule patte de fixation ne permettrait pas de s'affranchir de cette composante latérale.

Suivant un mode de réalisation, l'organe de plaquage comprend en outre au moins deux secondes pattes élastiquement déformables,
chaque seconde patte comprenant un bord de raccord rattachant la patte à la plaque et un bord d'extrémité libre, de sorte que les deux bords d'extrémité libres sont opposés et situés de part et d'autre d'un axe perpendiculaire à l'axe longitudinal de la plaque.

En particulier, les pattes s'étendent depuis la plaque suivant une direction transverse pour diverger l'une de l'autre.

Comme les premières pattes, les secondes pattes contribuent au plaquage de la pièce sur la surface avec une compensation des composantes latérales des efforts exercés par les pattes.

Suivant un mode de réalisation, les deux pattes sont en symétrie miroir.

Suivant un mode de réalisation, l'organe de plaquage comprend une pluralité de paires de premières pattes et/ ou de secondes pattes.

Suivant un mode de réalisation, la plaque comprend un trou, les bords du trou comprenant les bords de raccord des pattes. Le trou permet notamment un contrôle visuel du positionnement des pattes sur la pièce à plaquer.

Suivant un mode de réalisation, l'organe de plaquage comprend des moyens destinés à le fixer sur le support.

Suivant une variante, lesdits moyens de fixation sont formés d'au moins une paroi s'étendant sensiblement perpendiculairement depuis une périphérie de la plaque, ladite paroi se terminant par une découpe définissant deux pattes latérales (184) s'étendant du côté de la paroi qui est opposé à la plaque, de façon à former un angle aigu avec le plan de la paroi.

En particulier, ladite découpe peut définir en outre une patte centrale sensiblement perpendiculaire au plan de la plaque et comprise entre lesdites pattes latérales. La patte centrale facilite le déblocage des moyens de fixation avec le support.

L'invention concerne également un bloc électronique de puissance comportant un carter ayant une surface d'appui sur laquelle repose au moins un module électronique de puissance, le ou chaque module électronique de puissance comportant au moins un composant électronique de puissance, caractérisé en ce qu'il comprend
au moins un organe de plaquage selon l'invention, les pattes plaquant le module de puissance sur ladite surface d'appui.

Selon un mode de réalisation, les premières pattes de l'organe de plaquage viennent en appui sur un fond du module. Les pattes permettent donc de plaquer le module de puissance contre la surface en appuyant sur le fond.

Selon un mode de réalisation, le module comprend au moins un pion monté sur un fond du module, les premières pattes de l'organe de plaquage venant en appui sur ledit pion. Le pion définit une zone d'appui surélevée par rapport au fond du module. Ainsi, on peut prévoir des pattes plus courtes ce qui diminue l'encombrement de l'organe de plaquage.

Le composant électronique peut être monté sur le fond du module. Ce fond étant plaqué contre la surface, soit directement soit par l'intermédiaire d'un pion, le refroidissement du composant est amélioré lorsque la surface de plaquage assure une dissipation thermique du composant.

Selon un mode de réalisation, le fond du module électronique comprend une surface constituée de lames métalliques séparées par des interstices, lesdits interstices étant remplis par un matériau isolant électriquement. En particulier, le composant du module est monté sur une lame métallique.

Selon un mode de réalisation, le pion recouvre un interstice entre deux lames métalliques et des portions des deux lames métalliques situées de part et d'autre de l'interstice. Les lames métalliques peuvent être plus rigides que le matériau isolant remplissant les interstices. Lorsqu'un plaquage du fond est réalisé, ce différentiel de rigidité peut entrainer une pliure du fond le long d'un interstice. En appuyant, sur le matériau isolant et sur les lames métalliques, le pion recouvre ces deux surfaces de rigidités différentes et permet d'éviter l'occurrence d'une pliure le long de l'interstice.

Selon un mode de réalisation, la force de plaquage exercée par les premières pattes a une composante dans le plan du fond, dite composante latérale, et dans la zone recouverte par le pion, l'interstice et les lames métalliques ont des frontières qui sont suivant une direction sensiblement parallèle à ladite composante latérale. En effet, si la composante latérale était dans une autre direction par rapport aux frontières de l'interstice et des lames métalliques, par exemple perpendiculaire, la composante latérale de la force exercée par les pattes pourrait localement entraîner un décollement entre la matière isolante et les lames métalliques contigües. En étant parallèle aux frontières entre les lames métalliques et la matière isolante, la composante latérale est neutre par rapport à l'attache de la matière isolante et des lames métalliques et n'exerce donc pas une contrainte d'arrachement de la matière isolante de sur les lames métalliques.

Ainsi, dans une variante, les premières pattes et le fond du module sont configurés de sorte que :
- la force de plaquage exercée par les premières pattes a une composante dans le plan du fond, dite composante latérale, et
- dans la zone recouverte par le pion, l'interstice et les lames métalliques ont des frontières qui sont suivant une direction sensiblement parallèle à ladite composante latérale.

Plus précisément, dans une variante, les premières pattes et le fond du module sont configurés de sorte que, dans la zone recouverte par le pion, l'interstice et les lames métalliques ont des frontières qui s'étendent suivant une direction sensiblement parallèle à une projection de la force de plaquage exercée par les premières pattes sur le plan du fond.

Plus particulièrement, dans une variante, les premières pattes s'étendant sensiblement suivant une direction, les premières pattes et le fond sont configurés de sorte que, dans la zone recouverte par le pion, une projection de la direction des premières pattes sur le plan du fond est sensiblement parallèle aux frontières entre l'interstice et les lames métalliques contigües à l'interstice.

Selon un mode de réalisation, le bloc comprend un organe de plaquage selon l'invention ayant des secondes pattes, et les deux secondes pattes viennent en appui sur des bords opposés du module électronique. Dans un cas particulier, les secondes pattes viennent en appui sur un rebord du module, notamment un rebord du fond du module. En appuyant sur les bords, les secondes pattes contribuent au plaquage du module de puissance.

Selon un mode de réalisation, le bloc comprend un organe de plaquage ayant des moyens de fixation, et le carter comprend au moins une encoche comprenant une paroi d'appui pour les moyens de fixation.

Selon un mode de réalisation, l'encoche est définie par une paroi du carter comprenant un rebord ayant une partie en forme de quart de cylindre, de sorte que lors de la mise en place de l'organe de plaquage les moyens de fixation glissent sur le quart de cylindre pour venir sur la paroi d'appui. Ainsi, l'organe de plaquage est maintenu en position par le contact entre les moyens de fixation et la paroi d'appui.

Lorsqu'il est monté dans un véhicule, le bloc de puissance peut être soumis à des vibrations. Dans l'art antérieur, il est connu d'insérer des vis dans des œillets du module pour fixer et plaquer le module de puissance contre le fond du carter. Les vis sont introduites dans des trous du carter revêtus d'un matériau plastique. Le matériau plastique est serré entre la vis et le carter. Cependant, sous l'effet de la chaleur, des vibrations, de l'effort de plaquage, ou du vieillissement du matériau, un relâchement de la matière plastique (fluage) peut apparaître, pouvant entraîner un jeu dans le maintien des vis, et alors la diminution de l'effort de plaquage du module de puissance. Ainsi, l'effort de plaquage exercé sur le module de puissance diminue. En utilisant un contact entre les moyens de fixation et la paroi d'appui plutôt qu'une vis, la robustesse du plaquage du module de puissance est améliorée.

L'invention concerne en outre un onduleur pour véhicule électrique comportant un bloc selon l'invention.

L'invention concerne en outre un bloc électronique de puissance comportant un carter ayant une surface d'appui sur laquelle repose au moins un module électronique de puissance, le ou chaque module électronique de puissance comportant au moins un composant électronique de puissance et un fond comprenant, notamment formé par, une surface constituée de lames métalliques séparées par des interstices, lesdits interstices étant remplis par un matériau isolant électriquement,
ledit bloc comprenant en outre :
- au moins un organe de plaquage comportant une plaque ayant une forme allongée suivant un axe longitudinal, et au moins une patte élastiquement déformable ayant un bord de raccord la rattachant à la plaque et un bord d'extrémité libre,
- au moins un pion monté sur le fond du module, ledit pion recouvrant un interstice entre deux lames métalliques et des portions des deux lames métalliques situées de part et d'autre de l'interstice,
la ou les pattes de l'organe de plaquage venant en appui sur ledit pion, en particulier par leur bord d'extrémité libre, de façon à plaquer le module de puissance sur ladite surface d'appui.

Selon une variante, la ou les pattes et le fond du module sont configurés de sorte que :
- la force de plaquage exercée par la ou les pattes a une composante dans le plan du fond, dite composante latérale, et
- dans la zone recouverte par le pion, l'interstice et les lames métalliques ont des frontières qui sont suivant une direction sensiblement parallèle à ladite composante latérale.

Selon une variante, l'organe de plaquage comporte au moins deux pattes élastiquement déformables, chaque patte comprenant un bord de raccord rattachant la patte à la plaque et un bord d'extrémité libre, destiné en particulier à plaquer le module sur le support.

En particulier, les deux pattes sont configurées pour plaquer la pièce sur la surface avec une compensation des composantes latérales des efforts exercés par les pattes. Cependant, du fait entre autres des incertitudes de fabrication, les composantes latérales des forces de plaquage peuvent ne pas être complètement compensées. En s'assurant que dans la zone recouverte par le pion, l'interstice et les lames métalliques ont des frontières qui sont suivant une direction sensiblement parallèle à la ou les composantes latérales, on évite l'apparition d'une contrainte d'arrachement de la matière isolante de sur les lames métalliques qui serait causée par des composantes latérales résiduelles.

Selon une variante, une ou plusieurs paires de pattes sont telles que les deux bords d'extrémité libres sont en regard et situés de part et d'autre de l'axe longitudinal de la plaque.

Selon une variante, une ou plusieurs paires de pattes sont telles que les deux bords d'extrémité libres sont opposés et situés de part et d'autre d'un axe perpendiculaire à l'axe longitudinal de la plaque.

Selon une variante, le bloc peut comprendre un module, notamment ayant un fond, tel que décrit dans le document EP1454516.

Selon une variante, le module du bloc comprend un couvercle configuré pour former un espace sensiblement fermé avec le fond du module. Le fond et/ou le couvercle peuvent comprendre au moins une ouverture permettant le passage de l'organe de plaquage. En particulier, le module, notamment son couvercle, peuvent être tels que décrits dans le document EP2536261.

Selon une variante, l'organe de plaquage comprend au moins deux premières pattes élastiquement déformables, chaque patte comprenant un bord de raccord rattachant la patte à la plaque et un bord d'extrémité libre destiné à plaquer ladite pièce, de sorte que les deux bords d'extrémité libres sont en regard et situés de part et d'autre de l'axe longitudinal de la plaque.

Ledit bloc électronique de puissance et/ou l'organe de plaquage peuvent comporter l'une quelconque des caractéristiques précédemment décrites qui leur sont compatibles.

Des modes de réalisation de l'invention vont maintenant être décrits à titre d'exemple en se rapportant aux dessins dans lesquels :
- la figure 1 est une vue en perspective d'un organe de plaquage;
- la figure 2 est une vue en perspective d'un organe de plaquage selon un mode de réalisation selon l'invention;
- la figure 3 est une vue en perspective d'un module de puissance destiné à être utilisé dans un mode de réalisation du bloc de puissance selon l'invention ;
- la figure 4 est une vue en perspective d'un bloc de puissance comprenant l'organe de plaquage de la figure 2 et le module de puissance de la figure 3 ;
- la figure 5 est une vue en perspective d'une portion du bloc de puissance destinée à recevoir les moyens de fixation de l'organe de la figure 2 ;
- la figure 6 est une vue en coupe du bloc de puissance de la figure 4 avec les moyens de fixation de l'organe venant sur la paroi d'appui ;
- la figure 7 est une vue en coupe d'un bloc de puissance comprenant l'organe illustré en figure 1.

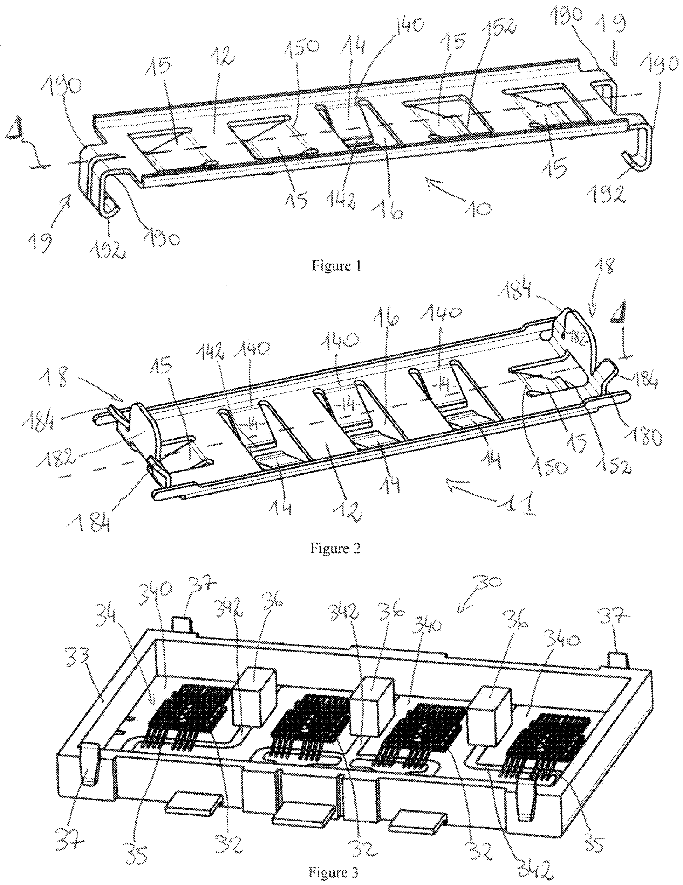

L'exemple d'organe de plaquage 10 montré en figure 1 comprend une plaque 12 qui présente une forme allongée suivant un axe longitudinal Δ.

L'organe 10 comprend des pattes 14, 15 élastiquement déformables destinées à exercer un plaquage d'une pièce sur un support. Les pattes 14, 15 s'étendent depuis la plaque 12 dans une direction transversale au plan de la plaque 12. Chaque patte 14, 15 comprend un bord de raccord 140, 150 qui la rattache à la plaque 12 et un bord d'extrémité libre 142, 152 destiné à appuyer sur la pièce.

En particulier, deux premières pattes 14 ont des bords d'extrémités en regard et sont situées de part et d'autre de l'axe longitudinal Δ de la plaque 12. Les deux premières pattes 14 sont en symétrie miroir, en particulier par rapport à un plan perpendiculaire à la plaque 12 et passant par son axe longitudinal Δ. Les deux premières pattes 14 s'étendent en vis-à-vis depuis un même trou 16 ménagé dans la plaque 12. Les bords du trou 16 comprennent les bords de raccord des pattes 14.

L'organe de plaquage 12 comprend en outre des paires de secondes pattes 15 dans lesquelles les bords d'extrémité libre 152 sont opposées et situées de part et d'autre d'un axe perpendiculaire à l'axe longitudinal Δ de la plaque 12. Les secondes pattes 15 sont en symétrie miroir, en particulier par rapport à un plan perpendiculaire à la plaque 12 et à son axe longitudinal Δ. Notamment, les pattes 15 d'une paire s'étendent depuis la plaque 12 en divergeant l'une de l'autre. Chaque patte 15 s'étend de la plaque 12 depuis un trou 16 respectif ménagé dans la plaque 12. Comme pour les premières pattes, les trous 16 comprennent les bords de raccord des pattes 15.

Deux extrémités opposées de la plaque 12 comprennent des moyens 19 destinés à fixer l'organe de plaquage 10 sur un support. Chacune de ces extrémités comprend deux ergots 190 qui s'étendent depuis la plaque 12 dans une direction sensiblement perpendiculaire par rapport à la plaque 12. L'extrémité distale d'un ergot 190 comprend une partie formant crochet 192 destinée à venir en prise avec le support. A une première extrémité, les ergots 190 sont proches de l'axe longitudinal Δ ; à la seconde extrémité, les ergots 190 sont éloignés de l'axe longitudinal Δ. Cette répartition des ergots 190 permet d'enchâsser plusieurs modules les uns à la suite des autres.

La figure 2 présente un mode de réalisation d'un organe de plaquage 11 selon l'invention. L'organe 11 de la figure 2 est similaire à l'organe 10 de la figure 1 à l'exception de ses moyens de fixation 18 et des nombres de paires de premières pattes 14 et de secondes pattes 15. Dans l'organe 11, trois paires de premières pattes 14 et une paire de secondes pattes 15 s'étendent depuis des trous 16 de la plaque 12.

Les moyens de fixation 18 sont formés d'une paroi 180 qui s'étend sensiblement perpendiculairement par rapport à la plaque 12 depuis une extrémité de la plaque. La paroi 180 se termine par une découpe qui définie une patte centrale 182 et deux pattes latérales 184. La patte centrale 182 est dans le prolongement de la paroi 180. Les pattes latérales 184 s'étendent du côté de la paroi 180 qui est opposé à la plaque 12 de façon à former un angle aigu avec la patte centrale 182.

La figure 3 présente un exemple de module de puissance 30 configuré pour être intégré dans un bloc de puissance selon l'invention. Le module de puissance est un module électronique IML qui comprend un ou plusieurs composants électroniques de puissance 32.

Le module électronique 30 a un fond 34 comprenant des lames métalliques 340, en cuivre par exemple, sur lesquelles sont montés les composants électroniques de puissance 32. Les composants électroniques de puissance 32 peuvent être notamment des composants bipolaires tels qu'une diode, des composants tripolaires tels qu'un transistor de type MOS ou IGBT ou un composant de plus grande complexité tel qu'un circuit intégré ASIC ou analogues. Les lames métalliques 340 sont séparées les unes des autres par un matériau diélectrique dans les interstices 342 entre les lames. Des fils conducteurs 35 réalisent les liaisons électriques des composants 32 vers des lames différentes de celle sur laquelle le composant 32 est monté. Un rebord 33 s'étend depuis la périphérie du fond 34. Un couvercle peut venir sur le rebord 33 de façon à couvrir le fond 34 et ainsi former un boîtier du module électronique de puissance 30 à l'aide d'attaches 37. Des lames conductrices 340 peuvent saillir à l'extérieur du rebord 33 afin de permettre une connexion des composants 32 à un réseau de puissance et/ou à un module électronique voisin.

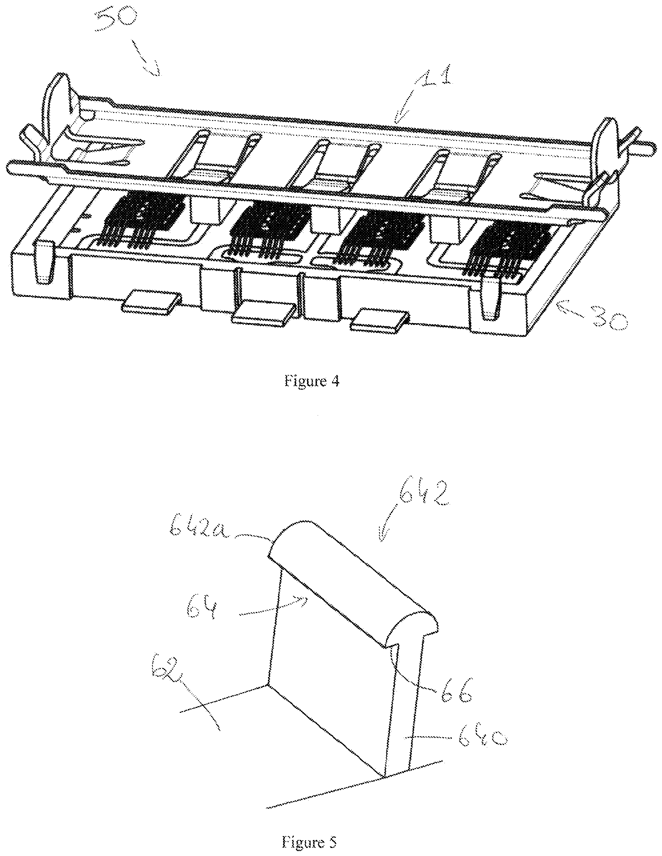

Le module électronique 30 comprend des pions 36 positionnés sur le fond 34. Chaque pion 36 recouvre une zone qui comprend une partie d'un interstice 342 et des parties des lames métalliques 340 contigües à l'interstice 342. Le pion 36 peut être intégral avec la matière isolante de l'interstice. Le pion 36 peut aussi être rapporté sur la matière isolante à l'aide d'une ouverture recevant un picot qui s'étend de la matière isolante de l'interstice 342. Le pion 36 peut être en un matériau différent du matériau de l'interstice 342. Les pions 36 forment une surface d'appui pour les pattes 14, 15 de l'organe de plaquage 10, 11 comme illustré en figure 4.

La figure 4 présente un exemple de bloc de puissance 50 selon l'invention dans lequel l'organe de plaquage 11 illustré en figure 2 vient plaquer le module électronique 30 de la figure 3 sur une surface (non représentée). Les paires de premières 14 et secondes 15 pattes appuient respectivement sur les pions 36 et le rebord 33, exerçant un effort qui permet de maintenir le module 30 en contact avec la surface. Cet effort comprend une composante sensiblement perpendiculaire au fond 34 du module 30 qui plaque celui-ci sur la surface.

L'effort de plaquage d'une patte 14, 15 peut aussi comprendre une composante latérale. Par exemple, la patte 14, 15 s'étend depuis la plaque 12 et vient sur le pion 36 ou le rebord 33 suivant une direction qui n'est pas perpendiculaire à la surface de plaquage et exerce donc un effort dans une direction qui est parallèle à la surface de plaquage.

Par exemple, l'effort latéral exercé par une seconde patte 14 peut entraîner le glissement du pion 36, voir son arrachage du fond 34. Dans une paire de premières pattes 14, les bords d'extrémité libres 142 étant en regard et situés de part et d'autre de l'axe longitudinal Δ, les composantes latérales des pattes 14 s'exercent avec une même intensité suivant une même direction mais dans des sens contraires, ce qui permet leur compensation réciproque. Ainsi, un glissement ou un arrachage du pion 36 provoqué par les pattes 14 est évité.

En outre, dans la zone du fond 34 recouverte par le pion 36, l'interstice 342 et les lames métalliques 340 ont des frontières qui sont suivant une direction sensiblement parallèle à la composante latérale. En étant parallèle aux frontières entre les lames métalliques 340 et la matière isolante de l'interstice 342, la composante latérale est neutre par rapport à l'attache de la matière isolante et des lames métalliques 340. Le risque d'arrachement de la matière isolante sur les lames métalliques 340 est diminué.

Dans la paire de secondes pattes 15, les bords d'extrémité libres 142 sont opposés et situés de part et d'autre d'un axe perpendiculaire à l'axe longitudinal Δ. Ainsi, les composantes latérales des secondes pattes 15 s'exercent sur le rebord 33 avec une même intensité suivant une même direction mais dans des sens contraires, ce qui permet leur compensation réciproque.

La compensation des forces latérales des pattes 14, 15 permet un maintien stable du module 30 sur sa surface de plaquage sans un déplacement latérale du module 30.

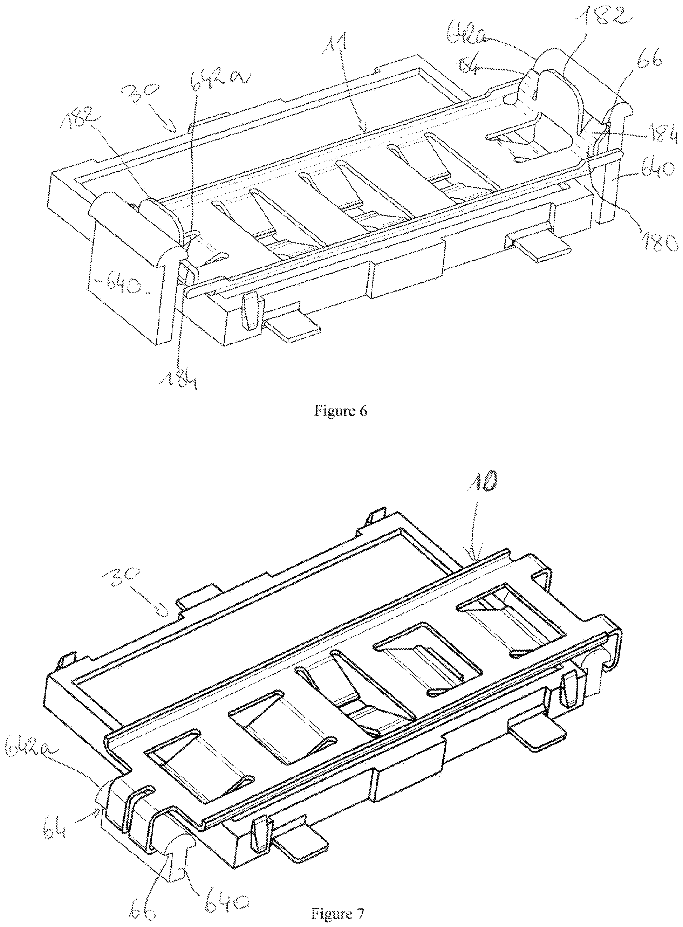

La fixation de l'organe de plaquage 11 dans le bloc de puissance 50 sera mieux comprise en faisant référence aux figures 5 et 6.

Une paroi 640 peut s'étendre de la surface de plaquage 62. La paroi 640 comprend un rebord 642 ayant une forme de demi-cylindre. Lors de la mise en place de l'organe de plaquage 11 sur le module 30, les pattes latérales 184 glissent sur la partie en forme de quart de cylindre 642a, tandis que les pattes 14, 15 viennent en appui sur le fond 34 et le rebord 33. Les pattes latérales 184 viennent ensuite en appui sur une paroi 66 formant un rayon du quart de cylindre 642a. L'organe de plaquage 11 est alors bloqué par l'encoche 64 formée par la paroi 640 et le rebord 642. En appuyant sur la face de la patte centrale 182 qui est opposée à la plaque 12, les pattes latérales 184 peuvent être glissées hors de l'encoche 64 débloquant ainsi l'organe de plaquage 11 et permettant de l'enlever du module de puissance 30. Cette opération de déblocage peut être assistée d'un bras de levier bras de levier placé entre la patte centrale 182 et le rebord 642.

La figure 7 illustre un exemple de fixation de l'organe 10 de la figure 1 sur une surface de plaquage 62. La surface de plaquage 62 est définie par le carter du bloc de puissance 50. Le rebord 642 de la paroi 640 est en périphérie de la surface de plaquage. La paroi 640 est une paroi latérale du carter. Lors de la mise en place de l'organe de plaquage 10 sur le module 30, la partie formant crochet 192 glisse sur la partie en forme de quart de cylindre 642a, tandis que les pattes 14, 15 viennent en appui sur le fond 34 et le rebord 33. La partie formant crochet 192 vient ensuite en appui sur la paroi d'appui 66 qui forme un rayon du quart de cylindre 642a. L'organe de plaquage 10 est alors bloqué par l'encoche 64 formée par la paroi 640 et le rebord 642. Pour débloquer l'organe de plaquage 10, la partie formant crochet 192 peut être extraite de l'encoche 64 grâce à l'utilisation d'un bras de levier placé entre l'ergot 190 et la paroi 640 ou le rebord 642

Une caractéristique des moyens de fixation 18, 19 va être décrite plus précisément. La résultante des efforts exercés par les premières 14 et secondes 15 pattes sur le module 30 peut entraîner une flexion de la plaque 12 dans un sens opposé à la composante perpendiculaire de l'effort de plaquage. Cette déformation de la plaque 12 provoque un déplacement des moyens de fixation 18, 19. Les moyens de fixation 18, 19 sont donc orientés de façon à ce que le déplacement provoqué par cette déformation soit opposé à une direction de décrochement des moyens de fixation.

En particulier, dans l'exemple illustré en figures 1 et 7, les crochets 192 sont dirigés vers la plaque 12. Lors de la déformation de la plaque 12, les crochets 192 sont ramenés sous la plaque 12 en appui dans l'encoche 64. Dans le mode de réalisation selon l'invention illustré en figures 2 et 5, les pattes latérales 184 sont dirigées de façon à s'éloigner de la plaque 12. Lors de la déformation de la plaque 12, les pattes latérales 184 sont repoussées dans l'encoche 64. Ainsi, dans ces deux cas, un déblocage de l'organe de plaquage 10, 11 du à la déformation de la plaque 12 est évité.

Bien entendu l'invention ne se limite pas aux exemples décrits mais est uniquement limitée aux revendications annexées. Notamment les moyens de fixation pourraient être différents. Ils pourraient être positionnés sur un emplacement quelconque de la périphérie de la plaque 12. En outre, l'organe de plaquage peut comprendre un nombre quelconque de paires de premières 14 et/ou de secondes 15 pattes.

## Revendications

1. Organe de plaquage (11) d'une pièce (30) sur une surface (62) d'un support, l'organe de plaquage étant notamment agencé pour être monté dans un bloc électronique de puissance, ledit organe (11) comprenant :
- une plaque (12) ayant une forme allongée suivant un axe longitudinal (Δ),
- au moins deux premières pattes (14) élastiquement déformables, chaque patte (14) comprenant un bord de raccord (140) rattachant la patte (14) à la plaque (12) et un bord d'extrémité libre (142), de sorte que les deux bords d'extrémité libres (142) sont en regard et situés de part et d'autre de l'axe longitudinal (Δ) de la plaque (12), et
des moyens (18) destinés à fixer l'organe sur le support comprenant au moins une paroi (180) s'étendant sensiblement perpendiculairement depuis une périphérie de la plaque (12), **caractérisé en ce que** ladite paroi se terminant par une découpe définissant deux pattes latérales (184) s'étendant du côté de la paroi qui est opposé à la plaque (12) de façon à former un angle aigu avec le plan de la paroi (180).

2. Organe de plaquage (11) selon la revendication 1, dans lequel ladite découpe définit en outre une patte centrale (182) sensiblement perpendiculaire au plan de la plaque (12) et comprise entre lesdites pattes latérales (184).

3. Organe de plaquage (11) selon la revendication 1 ou 2, comprenant en outre au moins deux secondes pattes (15) élastiquement déformables,
chaque seconde patte (15) comprenant un bord de raccord (150) rattachant la patte à la plaque (12) et un bord d'extrémité libre (152), de sorte que les deux bords d'extrémité libres sont opposés et situés de part et d'autre d'un axe perpendiculaire à l'axe longitudinal (Δ) de la plaque (12).

4. Organe de plaquage (11) selon l'une des revendications 1 à 3, dans lequel les deux pattes (14, 15) sont en symétrie miroir.

5. Organe de plaquage (11) selon l'une des revendications précédentes, dans lequel la plaque (12) comprend un trou (16), les bords du trou (16) comprenant les bords de raccord des pattes (14).

6. Bloc électronique (50) de puissance comportant un carter ayant une surface d'appui (62) sur laquelle repose au moins un module électronique (30) de puissance, le ou chaque module électronique (30) de puissance comportant au moins un composant électronique de puissance (32), **caractérisé en ce qu'**il comprend
au moins un organe de plaquage (10, 11) selon l'une des revendications 1 à 5, les pattes (14, 15) plaquant le module de puissance (30) sur ladite surface d'appui (62).

7. Bloc (50) de puissance selon la revendication 6 dans lequel les premières pattes (14) de l'organe de plaquage (10, 11) viennent en appui sur un fond (34) du module.

8. Bloc (50) selon la revendication 6 dans lequel le module comprend au moins un pion (36) monté sur un fond (34) du module, les premières pattes (14) de l'organe de plaquage (10, 11) venant en appui sur ledit pion (36).

9. Bloc (50) selon l'une des revendications 6 à 8 dans lequel le fond (34) du module électronique (30) comprend une surface constituée de lames métalliques (340) séparées par des interstices (342), lesdits interstices étant remplis par un matériau isolant électriquement.

10. Bloc (50) selon les revendications 8 et 9, dans lequel le pion (36) recouvre un interstice (342) entre deux lames métalliques (340) et des portions des deux lames métalliques (340) situées de part et d'autre de l'interstice.

11. Bloc selon la revendication 10, dans lequel les premières pattes (14) et le fond (34) du module sont configurés de sorte que :
- la force de plaquage exercée par les premières pattes (14) a une composante dans le plan du fond, dite composante latérale, et
- dans la zone recouverte par le pion (36), l'interstice (342) et les lames métalliques (340) ont des frontières qui sont suivant une direction sensiblement parallèle à ladite composante latérale.

12. Bloc (50) selon l'une des revendications 6 à 11 comprenant un organe de plaquage (11) selon la revendication 3, dans lequel les deux secondes pattes (15) viennent en appui sur des bords opposés du module électronique.

13. Bloc (50) selon l'une des revendications 6 à 12, dans lequel le carter comprend au moins une encoche (64) comprenant une paroi d'appui (66) pour les moyens de fixation (18, 19).

14. Bloc (50) selon la revendication 13 dans lequel l'encoche (64) est définie par une paroi (640) du carter comprenant un rebord (642) ayant une partie en forme de quart de cylindre (642a), de sorte que lors de la mise en place de l'organe de plaquage (10, 11) les moyens de fixation (18, 19) glissent sur le quart de cylindre (642a) pour venir sur la paroi d'appui (66).

15. Bloc (50) selon l'une des revendications 6 à 14, dans lequel le module (30) comprend un couvercle configuré pour former un espace sensiblement fermé avec le fond (34) du module, le fond (34) et/ou le couvercle comprenant au moins une ouverture permettant le passage de l'organe de plaquage (11).

16. Onduleur pour véhicule électrique comportant un bloc (50) suivant l'une des revendications 6 à 15.

## Patentansprüche

1. Körper (11) zum Pressen eines Teils (30) auf eine Oberfläche (62) eines Trägers, wobei der Presskörper insbesondere dazu vorgesehen ist, in einer elektronischen Steuereinheit montiert zu sein, wobei der Körper (11) umfasst:
- eine Platte (12), die eine längliche Form entlang einer Längsachse (Δ) hat,
- mindestens zwei erste elastisch verformbare Klauen (14), wobei jede Klaue (14) einen Anschlussrand (140), der die Klaue (14) an die Platte (12) anschließt, und einen freien Endrand (142) umfasst, so dass die zwei freien Endränder (142) einander gegenüberliegen und beiderseits der Längsachse (Δ) der Platte (12) angeordnet sind, und
- Mittel (18), die dazu bestimmt sind, den Körper auf dem Träger zu befestigen, umfassend mindestens eine Wand (180), die sich im Wesentlichen senkrecht von einer Peripherie der Platte (12) aus erstreckt,
**dadurch gekennzeichnet, dass** die Wand mit einem Ausschnitt endet, der zwei seitliche Klauen (184) definiert, die sich auf der Seite der Wand erstrecken, die der Platte (12) gegenüberliegt, um einen spitzen Winkel mit der Ebene der Wand (180) zu bilden.

2. Presskörper (11) nach Anspruch 1, bei dem der Ausschnitt ferner eine zentrale Klaue (182) definiert, die im Wesentlichen senkrecht auf die Ebene der Platte (12) und zwischen den seitlichen Klauen (184) eingefügt ist.

3. Presskörper (11) nach Anspruch 1 oder 2, ferner umfassend mindestens zwei zweite elastisch verformbare Klauen (15), wobei jede zweite Klaue (15) einen Anschlussrand (150), der die Klaue an die Platte (12) anschließt, und einen freien Endrand (152) umfasst, so dass die zwei freien Endränder einander gegenüberliegen und beiderseits einer Achse senkrecht auf die Längsachse (Δ) der Platte (12) angeordnet sind.

4. Presskörper (11) nach einem der Ansprüche 1 bis 3, bei dem die zwei Klauen (14, 15) spiegelsymmetrisch sind.

5. Presskörper (11) nach einem der vorhergehenden Ansprüche, bei dem die Platte (12) ein Loch (16) umfasst, wobei die Ränder des Loches (16) die Anschlussränder der Klauen (14) umfassen.

6. Elektronische Steuereinheit (50), umfassend ein Gehäuse mit einer Auflagefläche (62), auf der mindestens ein elektronisches Steuermodul (30) liegt, wobei das oder jedes elektronische Steuermodul (30) mindestens eine elektronische Leistungskomponente (32) umfasst, **dadurch gekennzeichnet, dass** sie mindestens einen Presskörper (10, 11) nach einem der Ansprüche 1 bis 5 umfasst, wobei die Klauen (14, 15) das Steuermodul (30) auf die Auflagefläche (62) pressen.

7. Steuereinheit (50) nach Anspruch 6, bei der die ersten Klauen (14) des Presskörpers (10, 11) auf einem Boden (34) des Moduls zur Auflage gelangen.

8. Einheit (50) nach Anspruch 6, bei der das Modul mindestens einen Stift (36) umfasst, der auf einem Boden (34) des Moduls montiert ist, wobei die ersten Klauen (14) des Presskörpers (10, 11) auf dem Stift (36) zur Auflage gelangen.

9. Einheit (50) nach einem der Ansprüche 6 bis 8, bei der der Boden (34) des Elektronikmoduls (30) eine Fläche umfasst, die von Metallblättchen (340) gebildet ist, die durch Zwischenräume (342) getrennt sind, wobei die Zwischenräume mit einem elektrisch isolierenden Material gefüllt sind.

10. Einheit (50) nach den Ansprüchen 8 und 9, bei der der Stift (36) einen Zwischenraum (342) zwischen zwei Metallblättchen (340) und Abschnitten der zwei Metallblättchen (340), die sich beiderseits des Zwischenraums befinden, abdeckt.

11. Einheit nach Anspruch 10, bei der die ersten Klauen (14) und der Boden (34) des Moduls eingerichtet sind, so dass:
- die von den ersten Klauen (14) ausgeübte Presskraft eine Komponente in der Ebene des Bodens hat, seitliche Komponente genannt, und
- in der von dem Stift (36) abgedeckten Zone der Zwischenraum (342) und die Metallblättchen (340) Grenzen haben, die sich entlang einer Richtung im Wesentlichen parallel zu der seitlichen Komponente befinden.

12. Einheit (50) nach einem der Ansprüche 6 bis 11, umfassend einen Presskörper (11) nach Anspruch 3, bei dem die zwei zweiten Klauen (15) auf den gegenüberliegenden Rändern des Elektronikmoduls zur Auflage gelangen.

13. Einheit (50) nach einem der Ansprüche 6 bis 12, bei der das Gehäuse mindestens eine Kerbe (64) umfasst, umfassend eine Stützwand (66) für die Befestigungsmittel (18, 19).

14. Einheit (50) nach Anspruch 13, bei der die Kerbe (64) durch eine Wand (640) des Gehäuses definiert ist, umfassend einen Rand (642) mit einem Teil in Form eines Viertelzylinders (642a), so dass bei der Anordnung des Presskörpers (10, 11) die Befestigungsmittel (18, 19) auf dem Viertelzylinder (642a) gleiten, um auf die Stützwand (66) zu gelangen.

15. Einheit (50) nach einem der Ansprüche 6 bis 14, bei der das Modul (30) einen Deckel umfasst, der eingerichtet ist, um einen im Wesentlichen geschlossenen Raum mit dem Boden (34) des Moduls zu bilden, wobei der Boden (34) und/oder der Deckel mindestens eine Öffnung umfassen, die den Durchgang des Presskörpers (11) ermöglicht.

16. Wechselrichter für ein Elektrofahrzeug, umfassend eine Einheit (50) nach einem der Ansprüche 6 bis 15.

## Claims

1. Body (11)for pressing a part (30) against a surface (62) of a support, the pressing body being in particular arranged to be mounted in a power electronic power unit, said body (11) comprising:
- a plate (12) having an elongate form along a longitudinal axis (Δ),
- at least two elastically deformable first tabs (14), each tab (14) comprising a connection edge (140) connecting the tab (14) to the plate (12) and a free end edge (142), such that the two free end edges (142) face one another and are located on either side of the longitudinal axis (Δ) of the plate (12), and
means (18) designed for fixing the body on the support, comprising at least one wall (180) extending substantially perpendicularly from a periphery of the plate (12), **characterized in that** said wall terminates in a cutout defining two lateral tabs (184) extending from the side of the wall which is opposite the plate (12) so as to form an acute angle with the plane of the wall (180).

2. Pressing body (11) according to Claim 1, wherein said cutout further defines a central tab (182) substantially perpendicular to the plane of the plate (12) and included between said lateral tabs (184) .

3. Pressing body (11) according to Claim 1 or 2, further comprising at least two elastically deformable second tabs (15),
each second tab (15) comprising a connection edge (150) connecting the tab to the plate (12) and a free end edge (152) in such a manner that the two free end edges are opposite and located on either side of an axis perpendicular to the longitudinal axis (Δ) of the plate (12).

4. Pressing body (11) according to one of Claims 1 to 3, wherein the two tabs (14, 15) are mirror-symmetrical.

5. Pressing body (11) according to one of the preceding claims, wherein the plate (12) comprises a hole (16), the edges of the hole (16) comprising the connection edges of the tabs (14).

6. Power electronic unit (50) comprising a housing having a bearing surface (62) on which at least one power electronic module (30) rests, the or each power electronic module (30) comprising at least one power electronic component (32), **characterized in that** it comprises
at least one pressing body (10, 11) according to one of Claims 1 to 5, the tabs (14, 15) pressing the power module (30) against said bearing surface (62).

7. Power unit (50) according to Claim 6, wherein the first tabs (14) of the pressing body (10, 11) bear against a bottom (34) of the module.

8. Unit (50) according to Claim 6, wherein the module comprises at least one pin (36) mounted on a bottom (34) of the module, the first tabs (14) of the pressing body (10, 11) bearing on said pin (36).

9. Unit (50) according to one of Claims 6 to 8, wherein the bottom (34) of the electronic module (30) comprises a surface constituted by metal strips (340) separated by gaps (342), said gaps being filled with an electrically insulating material.

10. Unit (50) according to Claims 8 and 9, wherein the pin (36) covers a gap (342) between two metal strips (340) and portions of the two metal strips (340) located on either side of the gap.

11. Unit according to Claim 10, wherein the first tabs (14) and the bottom (34) of the module are configured such that:
- the pressing force exerted by the first tabs (14) has a component in the plane of the bottom, referred to as the lateral component, and
- in the zone covered by the pin (36), the gap (342) and the metal strips (340) have boundaries that are in a direction substantially parallel to said lateral component.

12. Unit (50) according to one of Claims 6 to 11, comprising a pressing body (11) according to Claim 3, wherein the two second tabs (15) bear on opposite edges of the electronic module.

13. Unit (50) according to one of Claims 6 to 12, wherein the housing comprises at least one notch (64) comprising a bearing wall (66) for the fixing means (18, 19).

14. Unit (50) according to Claim 13, wherein the notch (64) is defined by a wall (640) of the housing comprising a flange (642) having a quarter-cylinder-shaped part (642a) such that upon installation of the pressing body (10, 11) the fixing means (18, 19) slide over the quarter cylinder (642a) to rest on the bearing wall (66).

15. Unit (50) according to one of Claims 6 to 14, wherein the module (30) comprises a cover configured such as to form a substantially closed space with the bottom (34) of the module, the bottom (34) and/or the cover comprising at least one opening allowing the passage of the pressing body (11).

16. Inverter for an electric vehicle, comprising a unit (50) according to one of Claims 6 to 15.
